## Europäisches Patentamt

## European Patent Office

## Office européen des brevets

(19)

(11) Veröffentlichungsnummer: **0 039 445**
**B1**

(12) **EUROPÄISCHE PATENTSCHRIFT**

(45) Veröffentlichungstag der Patentschrift: **30.09.87**

(51) Int. Cl.⁴: **H 05 K 3/02, G 03 F 7/20**

(21) Anmeldenummer: **81103037.8**

(22) Anmeldetag: **22.04.81**

(54) **Vorrichtung zum Belichten von Trägerplatten für gedruckte elektrische Schaltungen.**

(30) Priorität: **07.05.80 IT 2184080**

(43) Veröffentlichungstag der Anmeldung:
**11.11.81 Patentblatt 81/45**

(45) Bekanntmachung des Hinweises auf die
Patenterteilung:
**30.09.87 Patentblatt 87/40**

(84) Benannte Vertragsstaaten:
**AT BE CH DE FR GB LI LU NL SE**

(56) Entgegenhaltungen:

**IBM TECHNICAL DISCLOSURE BULLETIN;
Band 13, Nr. 5, Oktober 1970, Seite 1402, IBM
Corp., New York, USA, H.L. BROOKS et al.:
"Contact printer mounting"**

**WESTERN ELECTRIC TECHNICAL DIGEST, Nr.
29, Januar 1973, Seiten 1-2, New York, USA,
R.J. ALBANESE et al.: "Masking fixture for
exposing printed circuit boards"**

(73) Patentinhaber: **Curti, Ezio
Viale Regina Giovanna, 38
I-20100 Milano (IT)**

(72) Erfinder: **Curti, Ezio
Viale Regina Giovanna, 38
I-20100 Milano (IT)**

(74) Vertreter: **Mayer, Hans Benno
Via dell'Orso 7/A
I-20121 Milano (IT)**

(56) References cited:
**IBM TECHNICAL DISCLOSURE BULLETIN,
Band 14, Nr. 5, Oktober 1971, Seite 1431, IBM
Corp., New York, USA, G.J. GIUFFRE et al.:
"Double-sided exposure vacuum chamber"**

Courier Press, Leamington Spa, England.

EP 0 039 445 B1

## Beschreibung

Die vorstehende Erfindung betrifft eine Vorrichtung zum Belichten der Traegerplatten fuer elektrische Schaltkreise, gemaess dem Oberbegriff des Anspruchs 1.

Es ist bekannt, dass die Traegerplatten fuer elektrische Schaltkreise auf einer oder auf beiden Seiten mit einer metallischen Schicht, vorzugsweise einer Kupferschicht, sowie mit einer fotoempfindlichen Schicht, ueberzogen sind, wobei auf die fotoempfindliche Schicht meistens ein durchsichtiger Film aufgelegt wird, der den Verlauf des elektrischen Schaltkreises aufnimmt. Wird nun die eine oder aber beide der fotoempfindlichen Oberflaechen, auf denen die durchsichtigen Filme mit dem Schaltungsverlauf aufliegen, unter Verwendung einer Lichtquelle belichtet, so erzielt man z.B. die Polimerisation der entsprechenden fotoempfindlichen Schicht. Unter Zuhilfenahme entsprechender, darauffolgender chemischer Behandlungsschritte, werden von der Traegerplatte die Flaechen der fotoempflindlichen Schicht, die nicht belichtet wurde, sowie die entsprechenden, darunterliegenden Metallflaechen ausgewaschen und entfernt, wodurch nach Durchfuehrung dieser Behandlung eine Traegerplatte vorliegt, die die gewuenschte elektrische Schaltung aufweist. Wie bereits anfangs erwaehnt, koennen diese elektrischen Schaltkreise nur auf einer Flaeche der Traegerplatte oder auch auf beiden Flaechen der Traegerplatte vorgesehen sein.

Um nun elektronische Schaltkreise hoechster Qualitaet und Praezision herstellen zu koennen, ist es unbedingt erforderlich, dass die durchsichtigen Filme, die den Plan der elektrischen Schaltkreises aufweisen, vollkommen ebenflaechig, auf der die Metallschicht, sowie die fotoempfindliche Schicht aufweisenden Traegerplatte aufliegen. Ferner ist es unbedingt erforderlich, dass die genannten Filme oertlich genau auf der Oberflaeche der Traegerplatte aufgelegt werden, Zu diesem Zweck, ist es bekannt geworden, dass die Traegerplatte der elektrischen Schaltung Bezugsbohrungen aufweist, die den Bezugsbohrungen im durchsichtigen Film, sowie im Aufnahmerahmen des Filmes entsprechen, wodurch es unter Zuhilfenahme von Positionierstiften und aenhlichen Hilfsmitteln moeglich ist, den aufzulegenden Film genau gegenueber der Traegerplatte oertlich auszurichten und zu positionieren.

Es erscheint einleuchtend, dass im Verlauf der Zeit, die in den Film eingestanzten Bezugsbohrungen, sofern der aufzulegende Film der den Verlauf des Schaltplanes wiedergibt, nicht in einem festen Rahmen angeordnet ist, zu einer Verformung und Aufweitung neigen. Somit wird nicht mehr die gewuenschte Garantie, hinsichtlich der Wiederholbarkeit der Positionierung, sowie hinsichtlich der genauen Ausrichtung des Filmes gegenueber der Traegerplatte geboten.

Um den Film einwandfrei eben auf der Oberflaeche der Traegerplatte fuer die Aufnahme des elektrischen Schaltkreises anzubringen, wird ueblicherweise ein sogenanntes Sandwichpaket hergestellt, wobei in der Mitte die Traegerplatte vorgesehen ist, die zwischen zwei Filmen angeordnet ist, die den Verlauf der zu uebertragenden Schaltungsplanes aufweisen.

Das so hergetellte Sandwichpaket, wird anschliessend in eine Huelle aus durchsichtigem Material eingefuehrt, und diese Huelle wird anschliessend versiegelt und die eingeschlossene Luft wird abgepumpt, um somit im Inneren der Umhuellung einen erheblichen Unterdruck zu schaffen, mit der Absicht, eine einwandfreie Auflage des Films der den Schaltungsplan enthaelt, auf der entsprechenden Oberflaeche der Treagerplatte fuer die elektrische oder elektronsiche Schaltung zu gewaehrleisten.

Ganz abgesehen davon, dass der Einsatz elastischer Filme, die den Verlauf der elektrischen oder elektronischen Schaltung wiedergeben, nicht zu unterschaetzende Schwierigkeiten hinsichtlich der geforderten Praezision mit sich bringt, besonders wenn die elektronischen Schaltkreise in Fachgebieten zum Einsatz kommen, in denen die groesstmoeglichen Zuverlaessigkeit und Praezision unbedingt erforderlich ist, so ist zu beruecksichtigen, dass in diesem Falle die genaue Anordnung der Filme auf den zwei Flaechen der Traegerplatte, sowie die Einfuehrung des so erzielten Sandwichpaketes in die durchsichtige Huelle, auch heute noch vollstaendig von Hand durchgefuehrt werden muss, eine Tatsache, die natuerliche einen erheblichen Aufwand an Arbeitskraeften zur Herstellung der Sandwichpakete mit sich bringt.

Die Herstellung eines dieser Sandwichpakete, sowie die Einfuehrung derselben in eine besondere Umhuellung, sowie die Erzeugung eines erheblichen Unterdruckes in der versiegelten Umhuellung, ist ausgesprochen teuer, nimmt erhebliche Zeit in Anspruch und befriedigt in keinster Weise die Anforderungen an eine rationelle, industrielle Fertigung mit hohen Qualitaetsmassstaeben.

Es ist ferner bekannt, dass zur Herstellung elektronischer Schaltungen, fuer die eine weitaus hoehere Genauigkeit gefordert wird, an Stelle der elastischen Filme, die den Verlauf des gewuenschten elektrischen Schaltplanes wiedergeben, auch haeufig Glasplatten Verwendung finden, die ebenfalls mit dem Verlauf des zu uebertragenden Schaltungsverlaufes versehen sind. Auch bei Verwendung dieser Glassplatten, ist es ueblich, von Hand und ausserhalb der Belichtungseinrichtung, ein Sandwichpaket herzustellen, das aus zwei Glasplatten besteht, die den zu uebertragenden Schaltungsverlauf aufweisen und zwischen sich die Traegerplatte fuer die elektrischen oder elektronischen Schaltkreise aufweisen, wobei auch in diesem Falle, die Traegerplatte metallische Schichten und fotoempfindliche Schichten in der vorher beschriebenen Weise aufweist.

Zum Ausrichten und Positionieren der Glasplatten auf der Traegerplatte, ist vorgesehen, dass eine der Glasplatten Bezugsstifte aufweist, die mit Bezugsbohrungen in der Traegerplatte in Verbin-

2

dung gebracht werden. Die Laenge der Bezugsstifte ist so gewaehlt, dass diese nicht nur die mittig angeordnete Traegerplatte fuer die elektrischen Schaltkreise aufnehmen, sondern auch mit der obersten Glasplatte in Wirkverbindung bringbar sind. Zu diesem Zwecke, weist auch die oberste Glasplatte entsprechende Bezugsbohrungen auf.

Das so hergestellte Sandwichpaket wird ueblicherweise in eine durchsichtige Huelle eingebracht, die versiegelt wird, und in der nach der Versiegelung, ein geringer Unterdruck hergestellt wird. Die Verwendung der Glasplatten in der bisher ueblichen Weise, kennzeichnet sich durch die bereits beschriebenen Nachteile fuer die elastischen Filme aus, mit dem Unterschied, dass bei Verwendung von Glasplatten, der im Inneren der durchsichtigen und versiegelten Huelle eingestellte Unterdruck, wesentlich bescheidenere Werte annehmen muss, da ein ueberhoehter Unterdruck unweigerlich und sofort ein Zerspringen und Brechen der Glasplatten mit sich bringen wuerde, da bekanntlich Glasplatten ausgesprochen bruchempfindlich, im Falle von Biegebelastungen, Laengenausdehnungen und punktfoermiger Belastung sind.

Da der Bedarf an gedruckten elektrischen Schaltungen hoechster Praezision staendig zunimmt, wurden in der Vergangenheit zahlreiche Versuche zur Behebung der angefuehrten Schwierigkeiten angestellte, ohne jedoch zum gewuenschten Erfolg zu gelangen und ohne Vorrichtungen zu schaffen, die fuer eine moderne Industrieproduktion geeignet waeren.

Aus der Vorveroeffentlichung Western Electric Technical Digest Nr. 29, Januar 1973, Seite 1—2, New York, USA, R. J. Albanese et al.: "Masking Fixture for exposing printed circuit boards" sind zwei Rahmen bekannt geworden, zwischen denen zwei Glasplatten angeordnet sind, auf denen die zu uebertragenden Stromlaufplaene angeordnet sind. Zwischen den Rahmen wird bei dieser Vorrichtung die zu belichtende Traegerplatte eingespannt.

Der Nachteil der bekannten Vorrichtung besteht darin, dass sie nicht in einer automatischen Anlage Verwendung finden kann, da das Einlegen und Ausrichten der zu belichtenden Platte zwischen den Glasscheiben viel zu aufwendig sein wuerde. Ferner treten bei dieser Vorrichtung unweigerlich die bereits geschilderten Nachteile auf, d.h. bei Dauerbetrieb wuerde die waehrend des Belichtungsvorganges erzeugte Waerme zu einer sehr starken Laengendehnung der Glasplatten fuehren, was zu einer erhoehten Bruchgefahr fuehren wuerde.

Eine weitere Belichtungsvorrichtung ist aus der Vorveroeffentlichung IBM Technical Disclosure Bulletin, Band 13, Nr. 5, Oktober 1970, Seite 1402, IBM Corporation USA, H. L. Brooks et al.: "Contact printed mounting" bekannt geworden. Auch diese Vorrichtung ist nicht fuer den Einsatz in automatisch arbeitenden Fertigungsanlagen geeignet. Bei dieser Vorrichtung ist ferner keine Belichtungsmoeglichkeit auf beiden Seiten der Traegerplatte gegeben.

Im wesentlichen besteht die bekannte Vorrichtung aus einer Grundplatte, die eine zu belichtende Traegerplatte ohne Zuhilfenahme von in Bohrungen eintretende Bezugsstifte festlegt.

Ueber der Grundplatte ist mittels vier senkrecht angeordneten saeulenartigen Fuehrungen ein auf- und abbewegbarer Rahmen vorgesehen, der ueber elastische Lager eine Glasplatte traegt, die mit dem zu uebertragenden Stromlaufplan versehen ist. Aufgrund der elastischen Lagerung des Belichtungsrahmens ist keine genaue Belichtung der Traegerplatte moeglich und eine Wiederholbarkeit des Belichtungsvorganges mit stets gleichbleibender Praezision ist ausgeschlossen.

Aufgabe der vorstehenden Erfindung ist es daher, eine Vorrichtung vorzuschlagen, mit der es moeglich ist die oben erwaehnten Nachteile des Standes der Technik zu vermeiden und die Moeglichkeit zu schaffen, die zu belichtenden Traegerplatten fuer gedruckte elektrische Schaltungen unter Zuhilfenahme von Glasplatten die den Verlauf der zu uebertragenden elektronischen Schaltkreise aufweist, der Belichtungswirkung der Lichtquellen auszusetzen und vor allem die Moeglichkeit zu schaffen, die Traegerplatten vollautomatisch zu behandeln und, eine einwandfreie und jederzeit wiederholbare Positionierung und Ausrichtung der Glasplatten gegenueber der Traegerplatte des Schaltkreises zu ermoeglichen und ferner den Einsatz eines Unterdruckes von erheblichem Wert zu erlauben, ohne dabei Gefahr zu laufen, dass aufgrund von auftretenden Verformungen und Waermeausdehnungen oder aufgrund von mechanischen Belastungen, die aufgrund der erhoehten Unterdruckes unvermeidbar sind, die Gefahr von Spruengen oder Bruechen fuer die Glasplatten, die den Verlauf der zu uebertragenden Schaltungen weidergeben, zu befuerchten ist.

Die erfindungsgemaesse Aufgabe wird bei der eingangs genannten Vorrichtung durch die kennzeichnenden Merkmale des Anspruchs 1 geloest.

Erfindungsgemass ist es vorteilhaft, zum Zwecke einer automtischen Beschickung der Vorrichtung, dass die Glasplatten von der zu belichtenden Traegerplatte wegbewegt oder auf diese zubewegt werden koennen, und dass ferner Bezugsbohrungen, beziehungsweise Bezugsstifte fuer eine gegenseitige Verbindung vorgesehen sind.

Es hat sich ferner als Vorteil erwiesen, dass zur Verminderung des mechanischen Aufwandes, die untere Glasplatte fest angeordnet ist, waehrend die obere Glasplatte gegenueber der Traegerplatte beweglich angeordnet ist.

Die Erfindung sieht ferner vor, dass jedem Federmittel Einstell- und Vorspannmittel zugeordnet sind.

Entsprechend der vorteilhaften Ausfuehrungsform der Erfindung, ist vorgesehen, dass jedes
Befestigungselement aus einer fest angeordneten
Backe, sowie aus einer beweglichen Backe
besteht, die ueber eine Schraube bewegbar und
einstellbar ist, und dass jede Backe auf der der
Glasplatte zugewandten Seite eine weiche, elastische Schutzschicht aufweist.

In vorteilhafter Weise, wird jede Glasplatte mindestens auf zwei gegenueberleigenden Seiten
von den Spannelementen aufgenommen. Fuer
die Erzeugung des Unterdruckes, ist erfindungsgemaess vorgesehen, dass die Querstuetzen des
Rahmens eine oder mehrere Durchgansbohrungen aufweisen, die mit einer Unterdruckpumpe in
Verbindung stehen.

Die Unterdruckpumpe ist in vorteilhafter Weise
derartig ausgelegt, dass ein Unterdruck mit sehr
hohen Werten einstellbar ist.

Eine weitere vorteilhafte Ausfuehrungsform der
vorstehenden Erfindung, sieht ferner vor, dass
zwischen den querliegenden Stuetzen, die die
Glasplatten tragen, Dichtungsmittel vorgesehen
sind.

Es hat sich ferner als vorteilhaft erwiesen, mit
den horizontalen Stuetzen schwenkbare Halterungen vorzusehen, die Blechprofile aufnehmen,
welche mit ihren freien Enden luftdicht, sowohl
auf den horizontalen Traegern als auch auf den
Glasplatten aufliegen.

Erdindlungsgemaess ist ferner vorgesehen,
dass die Blechprofile, das aus Glasplatten und
einer Traegerplatte bestehende Sandwichpaket,
luftdicht in Umfangsrichtung abschliessen und
somit um das Sandwichpaket eine sich in
Umfangsrichtung erstreckende luftdichte Kammer bilden, in der unter Zuhilfenahme einer entsprechenden Pumpe, ein Unterdruck herstellbar
ist.

Um unerwuenschte Biegemomente zu vermeiden, sieht eine besonders vorteilhafts Ausfuherungsform der Erfindung vor, dass das freie Ende
des Blechprofiles, das der Glasplatte zugewandt
ist, auf dieser innerhalb der Umfangslinie aufliegt,
die durch den Umfang der Traegerplatte des
elektronischen Schaltkreises festgelegt wird.

Um ein Anpassen der Blechprofile an die
Abmessungen der Glasplatten zu ermoeglichen,
sind die Blechprofile untereinander teleskopartig
verbunden.

Es hat sich ferner als vorteilhaft erwiesen, dass
die horizontal angeordneten Traeger von einem
steifen Rahmen aufgenommen werden, um somit
eine Positionierung und Einstellung der horizontalen Traeger zu ermoeglichen.

Um den Traeger in Vertikalrichtung bewegen zu
koennen, ist es vorteilhaft, den Traeger mit pneumatischen Arbeitszylindern oder aehnlichen Mitteln anzutreiben.

Es hat sich als besonders vorteilhaft erwiesen,
wenn auch die steifen Rahmen Bezugsbohrungen
und Bezugsstifte zum gegenseiten Zentrieren der
Platten aufweisen.

Ferner ist es vorteilhaft, die horizontalen Streben ueber Laengsprofile mit Schwalbenschwanzfuehrungen teleskopartig verschiebbar vorzusehen.

Die Erdindung wird nun anhand eines Beispieles genauer beschrieben und in den Zeichnungen
dargestellt.

Fig. 1 zeigt schematisch zwei auf Abstand zueinander stehenden Glasplatten, sowie eine zugefuehrte Traegerplatte;

Fig. 2 zeigt die zwei noch auf Abstand stehenden Glasplatten, mit der zwischen den Glasplatten positionierten Traegerplatte, sowie einer weiteren Traegerplatts in Wartestellung;

Fig. 3 zeigt die Traegerplatte mit den bereits in
die Bezugsbohrungen eingefuhrten Bezugsstiften, die von der unteren Glasplatte abstehen;

Fig. 4 zeigt die Traegerplatte, sowie die Glasplatten bereits zu einem Sandwichpaket vereint,
um so der Belichtung durch zwei Lichtquellen
ausgesetzt zu werden;

Fig. 5 zeigt das Sandwichpaket mit der oberen
abgehobenen Platt nach dem Belichtungsvorgang;

Fig. 6 zeigt die Traegerplatte nach dem Belichtungsvorgang in einer von der unteren Glasplatte
abgehobene Stellung;

Fig. 7 zeigt die belichtete Tragerplatte, die
bereits aus dem zwischen den Glasplatten gebildeten Raum abgfoerdert worden ist, wobei sich
zwischen den Glasplatten bereits die folgende, zu
belichtende Traegerplatte, befindet;

Fig. 8 zeigt in perspektivischer Ansicht und in
vergroessertem Masstab die zwei Glasplatten, die
die zu uebertragenden Stromlaufplaene aufweisen, sowie die Traegerplatte, die auf jeder Seite
mit einer Metallschicht sowie einer lichtempfindlichen Schicht versehen ist;

Fig. 9 zeigt in vergroessertem Masstab die
Glasplatten und die Traegerplatte gemaess Fig. 8,
nach ihrem Zusammenfuegen zu einem Sandwichpaket;

Fig. 10 zeigt im Schnitt entlang der Linie X—X

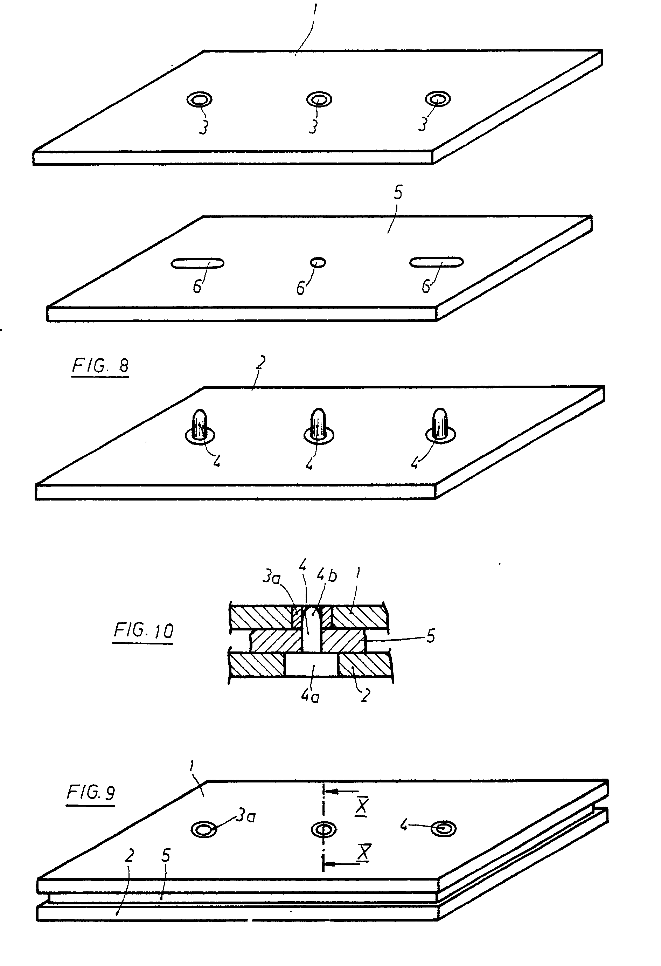

der Fig. 9, ein Detail eines Bezugstiftes, der durch
die Traegerplatte dringt und mit einer Bezugsbohrung in Verbindung steht, die in die obere Glasplatte eingearbeitet ist;

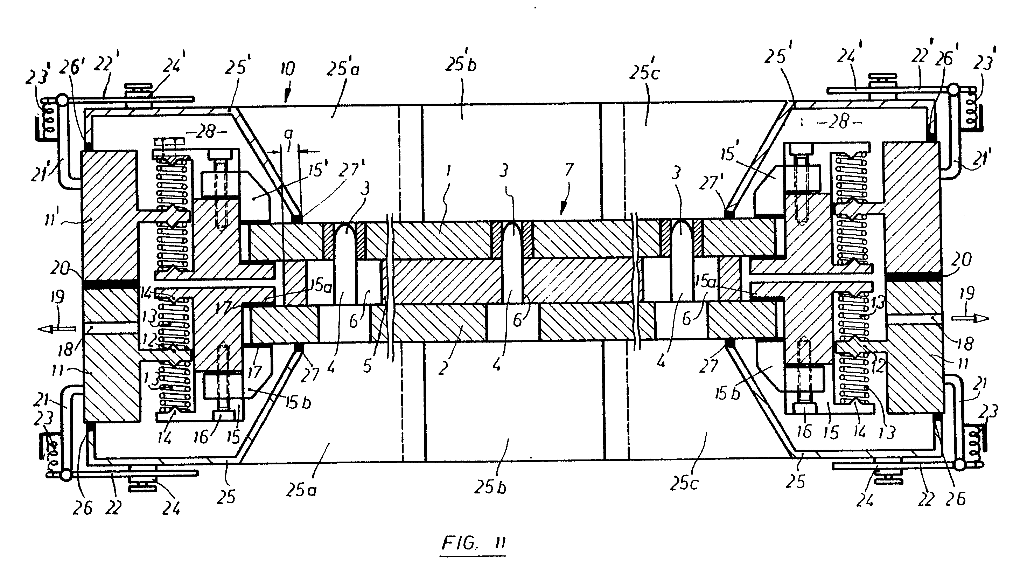

Fig. 11 zeigt im Schnitt entlang der Linie XI—XI

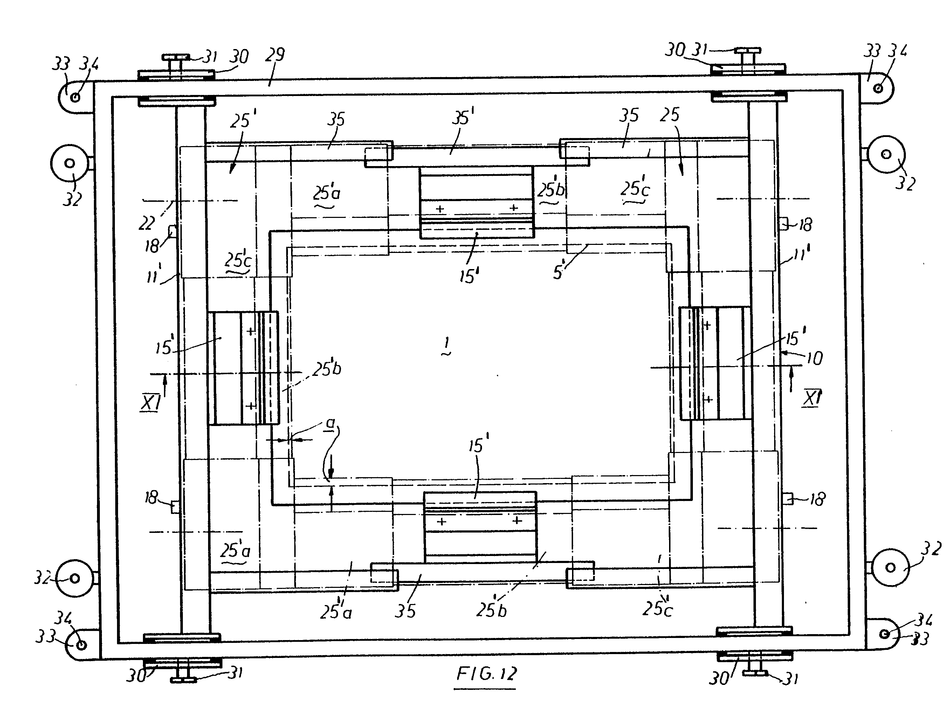

der Fig. 12, die erfindungsgemaesse Vorrichtung;

Fig. 12 zeigt die erfindungsgemaesse Vorrichtung in einer Draufsicht in Richtung des Pfeiles XII
der Fig. 11;

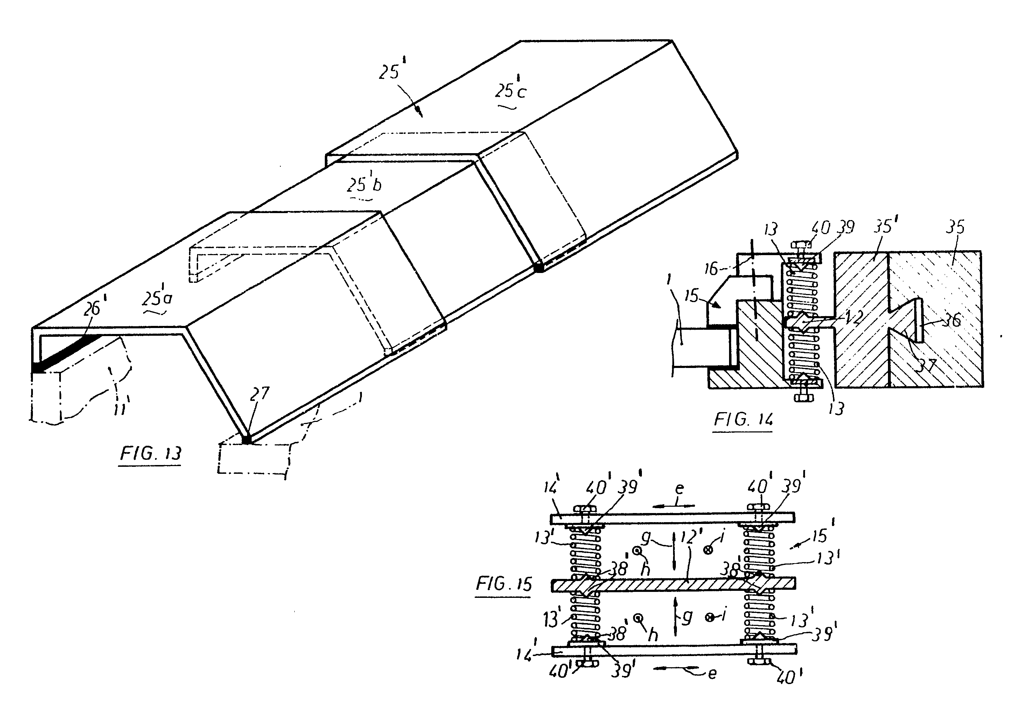

Fig. 13 zeigt in perspektivischer Ansicht ein
Detail der in Umfangsrichtung angeordneten
Blechprofile zur Bildung eines luftdichten Raumes;

Fig. 14 zeigt ein Detail im Schnitt, entlang der
Linie XIV—XIV der Fig. 12, eines Teilstueckes des
Klemmelementes, sowie eines Teilstueckes des
teleskopartig ausgebildeten, Halterahmens;

Fig. 15 zeigt ein Detail der Haltemittel fuer das
Klemmelement, im Schnitt entlang der Linie
XV—XV der Fig. 12.

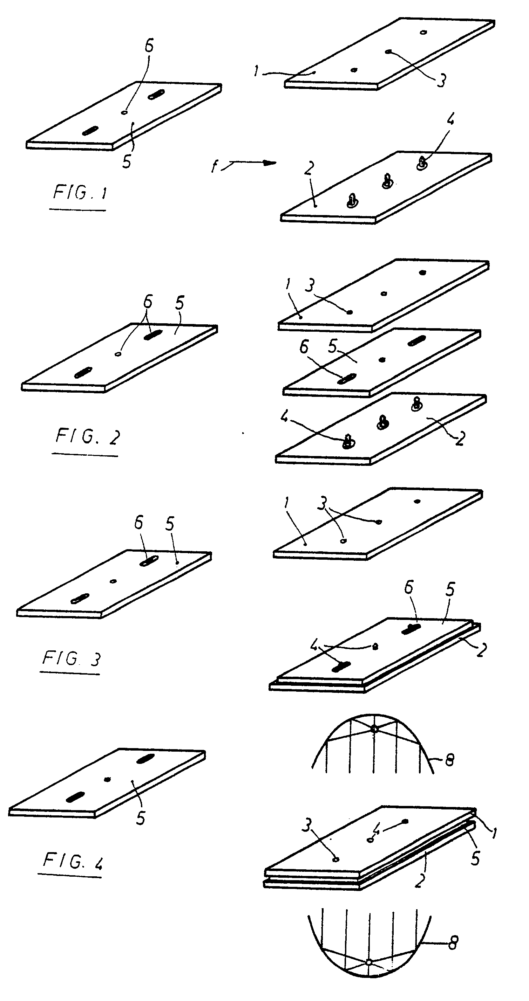

In den Figuren 1—7 sind schematisch in perspektivischer Ansicht, die verschiedenen Beschikkungs- sowie entnahmevorgaenge der Traegerplatte fuer die elektronischen Schaltkreise zwischen die Glasplatten dargestellt.

Wie der Fig. 1 zu entnehmen ist, sind vor Beginn des Belichtungsvorganges, die Glasplatten 1 und 2 auf gegenseitigem Abstand abgeordnet, die obere Platte 1 weist Ausricht- und Positionierbohrungen 3 auf, die mit entsprechenden Positionierstiften 4, die von der unteren Glasplatte 2 abstehen, in Wirkverbindung bringbar sind. Die oertliche Anordnung der Bohrungen 3 sowie der Bezugsstifte 4, kann frei gewaehlt werden. Die Traegerplatte 5 zur Aufnahme des elektronischen Schaltkreises, die sich entsprechend Fig. 1 in einer Wartestellung befindet, weist ebenfalls Bezugsbohrungen 6 auf, die mit den Stiften 4 in Wirkverbindung bringbar sind.

Durch eine Vorschubbewegung der Traegerplatte 5 in Richtung des Teiles f (Fig. 1), z.B. unter Zuhilfenahme eines mit Saugern ausgeruesteten Foerderers, der gleichmaessige, hin- und hergehende Foerderschritte ausfuehrt, wird die Traegerplatte 5 zwischen die Glasplatten 1, 2 eingebacht und eine weitere Traegerplatte 5 wird in eine Wartestellung gefoerdert, wie dies der Fig. 2 zu entnehmen ist.

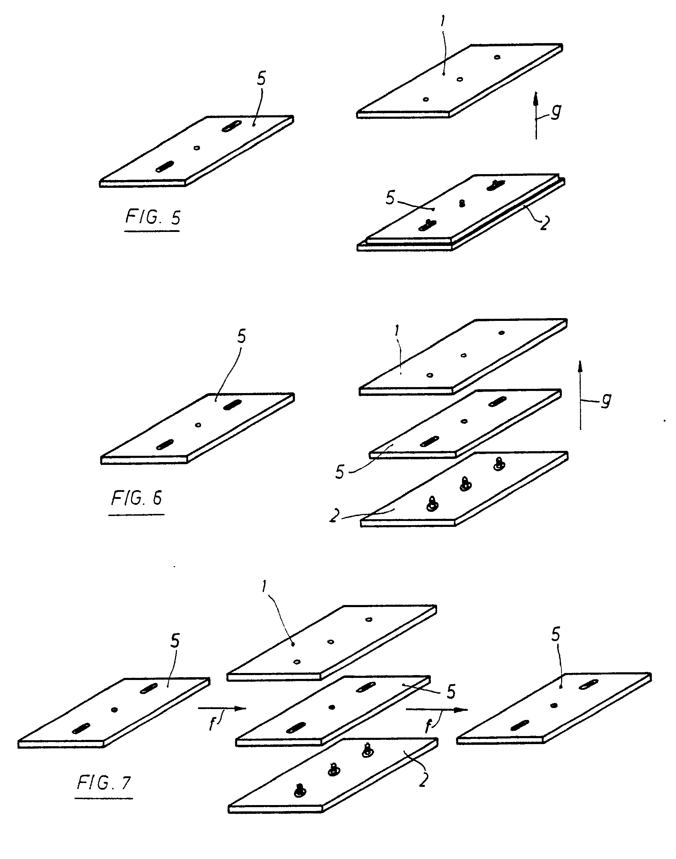

Aus der Fig. 3 kann entnommen werden, dass die Traegerplatte 5 bereits auf der unteren Glasplatte 2 die vorzugsweise fest angeordnet ist, angeordnet und ausgerichtet wurde, wobei in diesem Fall die Bezugsstifte 7 bereits in die Bohrungen 6 eingefuehrt worden sind.

Aus der Fig. 4 kann entnommen werden, dass auch die Glasplatte 1, unter Zuhilfenahme der Bezugsbohrungen 3 sowie der Bezugsstifte 4 auf der Traegerplatte 5 ausgerichtet und positioniert wurde, wodurch ein sandwichartiges Plattenpaket gebildet wird, das insgesamt mit 7 bezeichnet ist. Ferner sind ueber, sowie unter dem Sandwichpaket 7 Lichtquellen 8 und 9 angeordnet, die zur Belichtung der fotoempfindlichen Schichten der Traegerplatte 5 vorgesehen sind und zu diesem Zweck auf beiden Seiten der Traegerplatte 5 angeordnet sind.

Nach Belichten der Traegerplatte 5, wie der Fig. 5 zu entnehmen ist, wird die obere, beweglich angeordnete Glasplatte 1, in Richtung des Pfeiles g angehoben und im Anschluss daran, wie schematisch in Fig. 6 dargestellt ist, wird auch die Traegerplatte 5 von der unteren fest angeordneten Glasplatte 2 abgehoben, wie dies der Fig. 7 zu entnehmen ist und im Anschluss daran, wird die Traegerplatte 5 zur weiteren Behandlung in Richtung des Pfeiles f abtransportiert. Die Traegerplatte, die sich vorher in der Wartestellung befand, wird nunmehr zwischen die Glasplatten 1 und 2, die wiederum auf Abstand gebracht worden sind, eingefuehrt, und die Wartestellung wird von einer neuen, zu belichtenden Traegerplatte fuer elektronische Schaltkreis eingenommen.

Der Arbeitsablauf, der schematisch anhand der Figuren 1—7 beschrieben wurde, wiederholt sich nach Inbetriebnahme der Anlage in kontinuierlicher Weise.

Waehrend die Beschickung bzw. die Entladung der Traegerplatten 5 fuer die elektronischen Schaltkreise, mittels eines Saugfoerderers, der sich konstant ueber eine vorher eingestellte Foerderstrecke hin- und herbewegt, durchfuehrbar ist, war es bisher nicht moeglich, trotz eines erheblichen Beduerfnisses der Industrie, Mittel vorzuschlagen, die eine automatische Herstellung, ohne jegliche Handarbeit, fuer die Sandwichpakete 7 ermoelichten, die aus zwei Glasplatten 1, 2, bestehen, die auf die Flaechen der Traegerplatte 5 fuer den elektronischen Schaltkreise aufgelegt sind.

Diese Schwierigkeit ist in der Tatsache zu sehen, dass es bisher nicht moeglich war, einen erheblichen Unterdruck zwischen den in Verbindung stehenden Flaechen der Traegerplatte 5 und den entsprechenden Flaechen der Glasplatte 1 und 2 ohne Bruchgefahr zu schaffen.

Die in der Vergangenheit durchgefuehrten Versuche in dieser Richtung, wurden wieder aufgegeben, da sich ein erheblicher Ausschuss einstellte, teils durch Bruch der Glasplatten, sei es aufgrund des eingestellten Unterdruckes zwischen den in Beruehrung stehenden Platten, sei es aufgrund termischer Formaenderungen, die sich waehrend des Belichtungszeitraumes einstellten, wobei diese Formaenderungen bisher nicht ausgeglichen werden konnten. Ein weiterer Grund, auf den der Bruch der Glasplatten zurueckzufuehren ist, ist darin zu sehen, dass die beiden mit Kupfer beschichteten Flaechen der Traegerplatte niemals parallel zu den aufliegenden Glasplatten verlaufen.

Mit der erfindungsgemaessen Vorrichtung koennen die oben geschilderten Nachteile auf einfache Weise und vollstaendig vermieden werden.

In der Fig. 8, sind noch einmal in vergroessertem Masstab die zwei Glasplatten 1 und 2, sowie die dazwischenliegende Traegerplatte 5 fuer die Aufnahme der elektrischen Schaltkreise dargestellt.

Die untere Glasplatte 2, die fest angeordnet ist, weist Bezugsstifte 4 auf, die nach oben hin abstehen und am unteren Ende Verdickungen 4a aufweisen, mit denen die Bezugsstifte 4, z.B. in geeignete Bohrungen der fest angeordneten Glasplatte 2, eingeklebt sind.

Die Anordnung der Bezugsstifte 4 kann in freier Weise erfolgen und wird lediglich vom Verlauf des elektronischen Schaltkreises beeinflusst. Die Laenge der Bezugsstifte 4 wird in vorteilhafter Weise etwas kleiner gewaehlt als die Summe der Dicken der Traegerplatte 5, sowie der oben aufliegenden beweglichen Glasplatte 1.

In die Traegerplatte 5, wie bereits vorher erwaehnt, sind in Uebereinstimmung mit den Stiften 4, Bezugsbohrungen und Ausrichtbohrungen 6 eingearbeitet, von denen einige nach Art eines Langloches ausgefuehrt werden koennen, um eventuelle Formaenderungen aufgrund von Waermeeinwirkung zu erlauben. Die obere Glasplatte 1 weist Bezugs- und Ausrichtbohrungen 3 auf, die stets in Uebereinstimmung mit den Bezugsstiften 4 angeordnet sind. In vorteilhafter Weise, sind die Bohrungen 3 in Buchsen 3a eingearbeitet, die aus widerstandsfaehigem Material hergestellt sind, und die in die obere Glasplatte 1 eingeklebt sind.

Aus der Fig. 9 kann entnommen werden, dass die Umfangsabmessungen der Glasplatten 1 und 2 groesser gewaehlt sind als die Umfangsabmessungen der Traegerplatte 5 fuer den elektronischen Schaltkreis, wodurch die Glasplatten 1 und 2 entlang des gesamten Umfanges des Traegerplatte 5 etwas vorstehen.

Aus der Fig. 10, die ein Detail im Schnitt entlang der Linie X—X der Fig. 9 darstellt, kann die Verdickung 4a entnommen werden, die in die Glasplatte 2 eingeklebt ist, und von der der Bezugsstift 4 nach oben absteht, wobei der Bezugsstift an seinem oberen Ende in vorteilhafter Weise als Kegelspitze 4b ausgebildet ist, um somit die Einfuehrung in die Bohrung 6 der Traegerplatte 5, sowie in die Bohrung 3 der Buchse 3a der oberen, beweglich angeordneten Glasplatte 1 zu erleichtern.

Zur Belichtung wird das Plattenpaket, bestehend aus der beweglichen Glasplatte 1 mit den Bezugsbohrungen 3, der Traegerplatte 5 mit den Bezugsbohrungen 6 und der unteren, fest angeordneten Glasplatte 2, die mit den Bezugsstiften 4 versehen ist, in der in den Figuren 1—7 schematisch dargestellten Weise hergestellt.

Fuer die eigentliche Belichtung des Plattenpaketes wird die erfindungsgemaesse Vorrichtung, die mit 10 bezeichnet ist, und in der Fig. 11 in einem Querschnitt entlang der Linie XI—XI der Fig. 12 gezeichnet ist, verwendet.

Die Vorrichtung 10 besteht aus unteren Querstreben 11, die parallel zueinander angeordnet sind, wobei von diesen Querstreben 11 zur Innenseite hin eine Rippe 12 absteht, die zur Aufnahme elastischer Federmittel, z.B. von Schrauben- oder Druckfedern 13, ausgebildet ist. In vorteilhafter Weise, sind die Federmittel vorgespannt und liegen mit ihrem freien Ende an abstehenden Armen 14 an, die Teil einer Spanneinrichtung 15 bilden, dessen zur Querstrebe 11 hin gerichtete Seite, in vorteilhafter Weise in C-foermiger Art ausgebildet ist.

Jedes Spannelement 15 besteht aus einer festen Spannbacke 15a, sowie aus einer beweglichen Spannbacke 15b, die unter Zuhilfenahme einer Schraube 16 verschiebbar und einstellbar ausgebildet ist. Die Glasplatte 2 wird mit den Klemmeinrichtungen 15 auf gegenueberliegenden Seiten gespannt, ferner ist es moeglich, die Platte 2 auch auf allen vier Seiten durch geeignete Spanneinrichtungen festzulegen. In vorteilhafter Weise, weisen die Teile 15a, 15b der Spanneinrichtungen 15, auf der zur Platte 2 hin gerichteten Seite, eine Schutzbeschichtung 17 aus weichem und elastisch verformbarem Material, z.B. Gummi oder Kunststoff, auf.

Die Querstreben 11 weisen ferner eine Durchgangsbohrung 18 auf, die mit einer Unterdruckpumpe 19, zur Bildung eines Unterdruckes mit erheblichem Wert, vorgesehen ist.

Auch die bewegliche Glasplatte 1 ist, von Spannmitteln 15 festgelegt, die ebenso in der bereits vorher beschriebenen Weise mit weiteren parallel zueinander angeordneten Querstreben 11 verbunden ist.

Saemtliche Haltemittel fuer die obere Glasplatte 1, entsprechen den bereits beschriebenen Haltemitteln fuer die fest angeordnete untere Glasplatte 2 und somit werden diese bereits beschriebenen Bauteile mit den gleichen Bezugszeichen, unter Zufuegung des Indizes (') gekennzeichnet und nicht weiter beschrieben.

Zwischen den Querstreben 11 und 11' ist eine Dichtung 20 angeordnet, mit der es moeglich ist, die Verbindungszone zwischen den parallel angeordneten Querstreben 11 und 11' abzudichten. Mit jeder Querstrebe 11 bzw. 11' sind Haltearme 21, 21' verbunden, die einen Schwenkhebel 22, 22' tragen, der in vorteilhafter Weise als Kniehebel ausgebildet ist, wobei dessen kuerzerer Arm durch ein Federmittel 23, 23' beaufschlagt wird und der laengere Arm, unter Zwischenschaltung einer verschiebbaren Einstellhuelse 24, 24' ein Blechprofil 25, 25' traegt, das ueber Dichtungsmittel 26, 26' abdichten auf der entsprechenden Querstrebe 11, 11' sowie, unter Zwischenschaltung von Dichtungsmitteln 27, 27', auf den Glasplatten 1, 2 aufliegt, um somit eine dichte Kammer 28 zu bilden, die in Umfangsrichtung das gesamte Sandwichpaket 7, bestehend aus den Glasplatten 1, 2 und der Traegerplatte 5 fuer den elektrischen Schaltkreis, umgibt.

Es ist erfindungsgemaess sehr wichtig, dass die Auflagelinie 27, 27' des Profilbleches auf den Glasplatten 1, 2 auf jeden Fall im Inneren (a) der Umfangslinie, die die Flaeche der Traegerplatte 5 begrenzt, zu liegen kommt, wodurch waehrend der Herstellung des hohen Unterdruckes im Inneren der Kammer 28, jegliches Biegemoment in der Naehe der vorspringenden Raender der Platten 1 und 2 vermieden wird.

Die Blechprofile 25 und 25' umgeben das Sandwichpaket 7, bestehend aus den Glasplatten 1 und 2, sowie der Traegerplatte 5, in Umfangsrichtung, und es ist einleuchtend, dass die senkrechten Verbindungen zwischen den Blechprofilen 25, 25', die in Umfangsrichtung des Sandwichpakets 7 angeordnet sind, und die als Einzelstuecke 25a, 25b, 25c und 25a', 25b', und 25c', teleskopartig verschiebbar ausgebildet sind stets unter Zwischenfuegung bekannter und nicht dargestellter Dichtungsmittel abgedichtet sind.

Aus der Fig. 12, die eine Draufschicht der erfindungsgemaessen Vorrichtung 10 gemaess Fig. 11 zeigt, kann entnommen werden, dass die Querstreben 11' verschiebbar von einem rechtekkigen Rahmen 29 aufgenommen werden, der die Querstreben 11' unter Zuhilfenahme von Verschiebehuelsen 30 aufnimmt. Somit besteht die Moeglichkeit einer Anpassung der Querstreben 11' an die Abmessungen der Glasplatte 1, sowei ein Festlegen der Streben, unter Zuhilfenahme der Klemmschrauben 31 oder aehnlicher Mittel. Es ist einleuchtend, dass auch fuer die untere Querstrebe 11, ein dem Rahmen 20 identischer Aufnahmerahmen vorzusehen ist. Der nicht dargestellt untere Rahmen, der die Querstreben 11 traegt, ist dem oberen Rahmen 20 identisch, mit dem einzigen Unterschied, dass der untere Rahmen (nicht dargestellt), fest angeordnet ist, waehrend der obere Rahmen 29 (Fig. 12) auf- und abwaerts gegenueber der Horizontalebene bewegbar ist.

Zu diesem Zweck, finden Pneumatikzylinder 32 oder aehnliche Betaetigungsmittel Verwendung. Um den oberen, beweglichen Rahmen 29 gegenueber dem unteren fest angeordneten Rahmen zentrieren zu koennen, weist der obere Rahmen 20 Vorspruenge 33 und Zentrierbohrungen 34 auf, die mit entsprechenden Vorspruengen, die mit dem fest angeordneten unteren Rahmen verbunden sind und Zentrierstifte aufweisen (nicht dargestellt), in Wirkverbindung bringbar sind.

Die Querstreben 11', die die Spannelemente 15' tragen, sind ferner auf zwei gegenueberliegenden parallelen Seiten mit Laengsprofilen 35 wirkverbunden, und die Laengsprofile 35 sind in vorteilhafte Weise als Teleskopschienen ausgebildet, um somit ein einfaches Anpassen an die Laenge der zu belichtenden Platten zu ermoglichen.

Es kann vorteilhaft sein, wenn auch die Profilschienen 35 mit Spannmitteln 15' bestueckt sind. Diese Moeglichkeit ist jedoch als Alternative anzusehen, da die gewuenschten Ergebnisse bereits durch die Vorsehung der Spannmittel 15' an den Querstreben 11' erzielbar sind.

Den Querstreben 11' sind Profilflaeche 25' zugeordnet, die in einzelne Abschnitte 25a', 25b' und 25c' unterteilt sind. Die einzelnen Profilblechstuecke sind teleskopartig miteinander verbunden, um ein Positionieren und Anpassen der Profilbleche 25' (25) zur Abdichtung an die Abmessungen der verwendeten Glaspatten 1 (2) vorzunehmen. Die Profilbleche 25' umgeben die Glasplatte 1 in Umfangsrichtung und in den Deckzonen erfolgt ein gegenseitiges Ueberlappen und unter Verwendung bekannter Dichtungsmittel, wird ein absolut dichtes Umgreifen der Glasplatte 1 (2) vorgenommen, wodurch um das Sandwichpaket 7 herum eine dichte Kammer 28 gebildet wird. Auch aus der Fig. 12 kann man entnehmen, dass die inneren Enden der Blechprofile 25', die zur Abdichtung vorgehen sind, auf der Glasplatte 1 innerhalb der Umfangslinie 5' der zu belichtenten Traegerplatte 5 aufliegen. Hiermit wird sichergestellt, dass waehrend des Evakuierens der Kammer 28, die durch die Abdichtbleche 25' gebildet wird, kein Biegemoment auftreten kann, das waehrend der Herstellung des Unterdruckes in der Kammer 28 von dem Blechprofil 25 auf die Glasplatte 1 uebertragen werden kann, was einen sofortigen Bruch der Glasplatte 1 zur Folge haute.

Es ist naheliegend, das alle beschriebenen und in der Fig. 12 dargestellten Bauteile auch in Zusammenhang mit dem unteren fest angeordneten Rahmen (nicht dargestellt) vorgesehen sind, woebei diese Bauteile in diesem Falle spiegelbildlich angeordnet sind und die gleiche Funktion erfuellen. Aus diesem Grunde, sind diese Bauteile nicht mehr im einzelnen beschrieben. Der Fig. 13 kann ein Detail entnommen werden, das die teleskopartige Verbindung der Profilbleche 25' darstellt. Die Profilbleche 25a', 25b', 25c' sind ellbogenartig abgebogen und weisen an ihren Enden Dichtungsmittel 26' und 27' auf. Das Dichtungsmittel 26' liegt auf der Querstrebe 11' auf, wogegen das Dichtungsmittel 27' in der beschriebenen Art und Weise auf der Oberflaeche der oberen, beweglich angeordneten Glasplatte 1 aufliegt. Es ist einleuchtend, dass auch zwischen den einzelnen Bauteilen 25a', 25b' und 25c' an sich bekannte Dichtungsmittel angeordnet sind, die nicht weiter dargestellt werden.

Auch die Profilbleche 25, die den fest angeordneten unteren Querstreben zugeordnet sind, und in dieser Weise ausgebildet (Fig. 11).

Fig. 14 zeigt einen Schnitt entlang der Linie XIV—XIV der Fig. 12.

Der Fig. 14 kann eine praktische Ausfuehrungsform der teleskopartigen Profilschiene 35 entnommen werden. Die aeusseren Profilschienen 34 weisen eine Schwalbenschwanznut 36 auf, die in verschiebbarer Weise ein Profilstueck 35' aufnimmt, das mit einem schwalbenschwanzartigen Vorsprung 37 versehen ist. Mit dieser Verbindung 36, 37 zwischen den Profilschienen 35 und 35', ist es moeglich, eine Laengsverschiebung (Huelse 30) durchzufuehren und somit ein Anpassen an die Abmessungen der Platte 1 durchzufuehren. Mit der abstehenden Rippe 12', traegt die Profilschiene 35', unter Zwischenschaltung der bereits beschriebenen Federmittel 13', das Halteelemente 15' zur Aufnahme der oberen Glasplatte, die den zu uebertragenden Verlauf des elektrischen Schaltkreis aufweist, der durch fotografischen Belichtungsvorgang auf die Traegerplatte 5 zu uebertragen ist.

In Fig. 15 ist in einer Schnittdarstellung XV—XV der Fig. 11 die schwimmende Lagerung des Halteelementes 15' dargestellt.

Wie der Fig. 15 zu entnehmen ist, sind fuer jedes Halteelement zwei Federmittel 13' vorgesehen, die auf jeder Seite der Halterippe 12' angeordnet sind und in vorteilhafter Weise, weist das Auflager 13' Positioniervorspruenge 38' auf, die ein Ende des entsprechenden Federmittels 13' formschluessig aufnehmen. Es hat sich ferner als vorteilhaft erwiesen, in der Naehe der Arme 14' weitere Positioniervorspruenge 39' vorzusehen, die z.B. als bewegliche Platten ausgebildet sind, und in Wirkverbindung mit Schrauben 40' stehen, die in die Arme 14' eingeschraubt sind und somit erlauben, die Federmittel 13' einzustellen und diesen Federmitteln 13' eine gewissen Vorspannung zu erteilen.

Aufgrund der erfindungsgemaessen "schwimmenden" Lagerung der Halteelemente 15, koennen sich diese frei in Horizontalrichtung (Pfeil e), in Vertikalrichtung (Pfeil g), sowie senkrecht zur Zeichnungsebene (Pfeil h und i der Fig. 15) bewegen.

Die Arbeitsweise der erfindungsgemaessen Vorrichtung C ist folgende:

zuerst ist die obere, bewegliche Glasplatte 1 von der unteren, fest angeordneten Glasplatte 2, unter Zuhilfenahme der Zylinder 32, auf Abstand gestellt. Die Zylinder 32 sind mit dem oberen beweglichen Rahmen, der die Glasplatte 1 traegt, ueber die Querstrebe 11' wirkverbunden. Diese Stellung ist schematisch in Fig. 1 dargestellt.

Im Anschluss daran, wird zwischen die auf Abstand stehenden Platten 1 und 2 (unter Zuhilfenahme eines Saugfoerderers), die Traegerplatte 5 eingefuehrt und auf der unteren Glasplatte 2 abgesetzt und ausgerichtet, wie dies aus den Fig. 2 und 3 zu entnehmen ist. Schliesslich, unter Zuhilfenahme der Zylinder 32, wird die Glasplatte 1 auf die Traegerplatte 5 abgesenkt, und unter Zuhilfenahme der Bezugsstifte 4 sowie der Bezugsbohrungen 3, wird ein Sandwichpaket hergestellt, das gesamthaft mit 7 bezeichnet ist und schematisch in den Fig. 4, 9 und 10 dargestellt ist.

Vor Belichtung des Sandwichpaketes 7 unter Zuhilfenahme der Lichtquellen 8 und 9 (Fig. 4), wird im Inneren der Kammer 28 und somit auch zwischen den Flaechen der Glasplatten 1 und 2, die mit den Oberflaechen der dazwischenliegenden Tregerplatte 5 in Verbindung stehen, ein Unterdruk von erheblichem Ausmasse geschaffen, indem ueber die Durchgangsbohrungen 18 der unteren Querstreben 11, die mit einer geeigneten Unterdruckpumpe 19 in Wirkverbindung stehen, durch Auspumpen ein Unterdruck hergestellt wird.

Nur nach Erzeugung des gewuenschten Unterdruckes in der Kammer 28 und somit zwischen den Flaechen der Glasplatten 1 und 2 und den Flaechen der Traegerplatte 5, erfolgt die Belichtung, unter Zuhilfenahme der Lichtquellen 8 und 9, die zu beiden Seiten der Traegerplatte 5 angeordnet sind.

Aufgrund der erfindungsgemaessen "schwimmenden" Lagerung der Glasplatten, sowie der besonderen Ausfuehrung und Anordnung der abdichtenden Profilbleche 25, und 25', ist es moeglich geworden, in neuer und ueberraschender Weise, einen Unterdruck von erheblichen Werten einzusetzen, ohne dass die geringste Gefahr bestuende, dass die Glasplatten 1 und 2 einer Bruchgefahr ausgesetzt waeren. Dank der "schwimmenden" Lagerung, unter Zuhilfenahme der Spannelemente 15 und 15', koennen die Glasplatten 1 und 2 staendig eine Ausgleichsbewegung im Falle einer Ausdehnung ausfuehren und fener werden die vorspringenden Ende der Glasplatten 1 und 2 nicht durch Biegemomente in unguenstiger Weise beeinflusst, sondern lediglich durch Druckkraefte, die in gleichmaessiger Weise in Umfangsrichtung der Glassplatten 1 und 2 verteilt werden koennen.

Somit wird es unter Verwendung der erfindungsgemaessen Vorrichtung 10 zum ersten Mal moeglich, Traegerplatten 5 fuer elektronische Schaltkreise unter Zuhilfenahme von Glasplatten 1,2, die den Verlauf des Schaltkreises weidergeben, zu belichten und hierzu einen Unterdruck mit erheblichem Ausmass zu verwenden, und ohne Zuhilfenahme von Arbeitskraeften und Handarbeit, elektronische Schaltkreise vollautomatisch herzustellen und dabei, eine bisher nicht gekannte Genauigkeit einzuhalten.

**Patentansprueche**

1. Vorrichtung zum Belichten von Schaltkreis-Traegerplatten, welche sich zwischen zwei Glasplatten (1, 2) befinden, die mit den auf die Traegerplatte (5) zu uebertragenden Stromlaufplaenen versehen sind, dadurch gekennzeichnet, dass fuer jede Glasplatte (1, 2) Spannelemente (15) vorgesehen sind, zwischen denen die Raender der Glasplatten (1, 2) festspannbar sind, dass die Spannelemente (15) an der Glasplattenseite bewegliche Spannbacken (15', 15b) und auf der gegenueberliegenden Seite abstehende Arme (14) aufweisen, die mit dem jeweiligen Spannelement (15) ein C-foermiges Profil bilden, dass zwischen diesen Armen (14) Federmittel, wie z.B. Schraubenfedern angeordnet sind, die einerseits an den Armen anliegen, und andererseits mit ihren freien, aufeinander zu gerichteten Enden an den einander gegenueber liegenden Seiten einer vorspringenden Rippe (12) einer horizontal angeordneten Querstrebe (11) anliegen, wodurch die Spannelemente 6 elastisch gegenueber der Querstrebe (11) gelagert sind.

2. Vorrichtung, nach Patentanspruch 1, dadurch gekennzeichnet, dass jedem vorspringenden Arm (14) des C-foermig ausgebildeten Spannelements (15), mehrere, nebeneinander angeordnete Federmittel (136 zugeordnet sind (Fig. 15).

3. Vorrichtung, nach Patentanspruch 1 oder 2, dadurch gekennzeichnet, dass den elastischen Federmitteln (13) Einstell- und Vorspanneinrichtungen (40) zugeordnet sind.

4. Vorrichtung, nach Patentanspruch 1, dadurch gekennzeichnet, dass jedes Spannelement (15) aus einer feststehenden Spannbacke (15a) und einer beweglich angeordneten Spannbacke (15b) besteht, dass die bewegliche Spannbacke (15b) unter Zuhilfenahme von Schraubenmitteln (16) verschiebbar und einstellbar ist und, dass jede Spannbacke (15a, 15b) auf der der Glasplatte (1, 2) zugewandten Seite eine weiche, elastische Schutzschicht (17) ausweist.

5. Vorrichtung nach Patentanspruch 1, dadurch gekennzeichnet, dass jede Glasplatte (1, 2) mindestens auf zwei gegenuberliegenden Seiten von einem Spannelement (15) gehalten wird.

6. Vorrichtung, nach Patentanspruch 1, dadurch gekennzeichnet, dass die horizontal angeordneten Querstreben (11) eine oder mehrere Durchgangsbohrungen (18) aufweisen, die mit einer Unterdruckpumpe (19) in Wirkverbindung stehen.

7. Vorrichtung, nach Patentanspruch 1, dadurch gekennzeichnet, dass zwischen den horizontal angeordneten Querstreben (11), die die untere Glasplatte (2) aufnehmen, und den Querstreben (11'), die die obere Platte (1) aufnehmen, Dichtungsmittel (20) angeordnet sind.

8. Vorrichtung, nach Patentanspruch 7, dadurch gekennzeichnet, dass Profilbleche (25), die unter Zwischenschaltung von Dichtungsmitteln (26, 27), sowohl auf den horizontal angeordneten Querstreben (11), als auch auf der Oberflaeche der entsprechenden Glasplatte (1, 2), die den Oberflaechen der dazwischenliegenden Traegerplatte (5) gegenueberliegen, aufliegen, und dass die Profilbleche durch mit den horizontal angeordneten Querstreben (11) in Wirkverbindung stehenden schwenkbare Haltemittel (21, 22) unter Zuhilfenahme eines verschiebbaren und festlegbaren Haltestutzens (24) in einstellbarer Weise festgehalten werden.

9. Vorrichtung, nach Patentanspruch 8, dadurch gekennzeichnet, dass die Profilbleche (25) das aus Glasplatten (1, 2) und Traegerplatte (5) bestehende Sandwichpaket (7) in Umfangsrichtung, sowie die Aufnahmemittel (15) und die horizontal angeordneten Querstreben (11) absolut luftdicht umgeben und eine sich in Umfangsrichtung erstreckende, dichte Kammer (28) bilden, die ueber Durchgangsbohrungen (18), unter Zuhilfenahme einer Unterdruckpumpe (19), evakuierbar ist.

10. Vorrichtung, nach Patentanspruch 9, dadurch gekennzeichnet, dass das Ende eines jeden Profilbleches (25), welches zu den Glasplatten (1, 2) hin gerichtet ist, auf diesen im Inneren einer Flaeche aufliegt (a), die durch die Umfanglinien der Traegerplatte (5) fuer den elektronischen Schaltkreis beschrieben wird.

11. Vorrichtung, nach Patentanspruch 10, dadurch gekennzeichnet, dass die Profilbleche (25) miteinander teleskopartig verbunden sind und unter Zwischenschaltung von Dichtungsmitteln abgedichtet sind.

12. Vorrichtung, nach Patentanspruch 1, dadurch gekennzeichnet, dass die horizontal angeordneten Querstreben (11) von einem steifen Rahmen (29) aufgenommen werden.

13. Vorrichtung, nach Patentanspruch 12, dadurch gekennzeichnet, dass die horizontalen Querstreben (11) von dem Rahmen (29) in verschiebbarer und einstellbarer Weise, unter Zuhilfenahme von Schiebehuelsen (30), aufgenommen sind und, dass diese Schiebehuelsen (30) durch Spannschraube (31) in ihrer Lage festlegbar sind.

14. Vorrichtung, nach Patentanspruch 12, dadurch gekennzeichnet, dass der Rahmen (29), der eine in Vertikalrichtung beweglich angeordnete Glasplatte (1) aufnimmt, mit Betaetigungsmitteln wirkverbunden ist, z.B. pneumatischen Kolbenzylindereinheiten (32).

15. Vorrichtung, nach Patentanspruch 1, dadurch gekennzeichnet, dass die fest angeordneten Rahmen (29) Zentrierbohrungen (33, 34), sowie mit diesen in Wirkverbindung bringbare Zentrierstifte (33, 34) aufweisen.

16. Vorrichtung, nach Patentanspruch 1, dadurch gekennzeichnet, dass die horizontal angeordneten Querstreben (11), ueber parallel angeordnete Laengsprofile (35), z.B. mittels Schwalbenschwanzverbindungen (36, 37), verbunden und tekeskopartig verschiebbar angeordnet sind.

**Revendications**

1. Appareillage pour illuminer des plaquettes à circuit imprimé qui se trouvent entre deux plaques de verre (1, 2) comportant les schémas de câblage à transférer sur la plaquette (5), caractérisé en ce qu'il est prévu pour chaque plaque de verre (1, 2) des éléments de serrage (15) entre lesquels les bords des plaques de verre (1, 2) peuvent être bloqués, en ce que les éléments de serrage (15) comportent des mâchoires de serrage (15', 15b) mobiles du côté des plaques de verre et des bras en saillie (14) du côté opposé, qui forment avec l'élément de serrage (15) correspondant un profil en C, en ce que des moyens élastiques comme, par exemple, des ressorts hélicoïdaux sont placés entre ces bras (14) et sont d'une part, en contact avec les bras et sont, d'autre part, par leurs extrémités libres en regard, en contact avec les faces mutuellement opposées d'une nervure en saillie (12) d'une entretoise (11) disposée horizontalement, de sorte que les éléments de serrage (15) sont montés élastiquement par rapport à l'entretoise (11).

2. Appareillage selon la revendication 1, caractérisé en ce que plusieurs moyens élastiques contigus (13) sont rattachés à chaque bras en saillie (14) de l'élément de serrage en C (15) (figure 15).

3. Appareillage selon la revendication 1 ou 2, caractérisé en ce que des agencements de réglage et de précontrainte (40) sont rattachés aux moyens élastiques (13).

4. Appareillage selon la revendication 1, caractérisé en ce que chaque élément de serrage (15) comprend une mâchoire de serrage fixe (15a) et une mâchoire de serrage (15b) mobile, en ce que la mâchoire de serrage mobile (15b) peut être déplacée et positionnée à l'aide de moyens de vissage (16), et en ce que chaque mâchoire de serrage (15a, 15b) comporte une couche protectrice élastique molle (17) du côté de la plaque de verre (1, 2).

5. Appareillage selon la revendication 1, caractérisé en ce que chaque plaque de verre (1, 2) est retenue sur au moins deux côtés opposés par un élément de serrage (15).

6. Appareillage selon la revendication 1, caractérisé en ce que les entretoises (11) disposées horizontalement comportent un ou plusieurs passages (18) qui coopèrent avec un pompe à vide (19).

7. Appareillage selon la revendication 1, caractérisé en ce que des moyens d'étanchéité (20) sont placés entre les entretoises (11) disposées horizontalement, qui reçoivent la plaque de verre inférieure (2) et les entretoises (11') qui reçoivent la plaque supérieure (1).

8. Appareillage selon la revendication 7, caractérisé en ce que des tôles profilées (25) sont placées, avec interposition de moyens d'étanchéité (26, 27), à la fois sur les entretoises (11) disposées horizontalement et sur la surface de la plaque de verre correspondante (1, 2) se trouvant en regard des surfaces de la plaquette à circuit imprimée (5) interposée, et en ce que les tôles profilées sont retenues de façon réglable par des moyens de retenue pivotante (21, 22) coopérant avec les entretoises (11) disposées horizontalement, à l'aide d'un embout de retenue (24) pouvant être déplacé et immobilisé.

9. Appareillage selon la revendication 8, caractérisé en ce que les tôles profilées (25) entourent de façon absolument étanche à l'air l'empilement de structure sandwich (7) comprenant les plaques de verre (1, 2) et la plaquette à circuit imprimé (5), en direction périphérique, de même que les moyens de réception (15) et les entretoises (11) disposées horizontalement et constituent une chambre hermétique (28) s'étendant en direction périphérique dans laquelle on peut faire le vide par des passages (18) au moyen d'une pompe à vide (19).

10. Appareillage selon la revendication 9, caractérisé en ce que l'extrémité de chaque tôle profilée (25) qui est dirigée vers les plaques de verre (1, 2) repose sur elle à l'intérieur d'une surface (a) qui est décrite par les lignes périphériques de la plaquette à circuit imprimé (5) pour le circuit électronique.

11. Appareillage selon la revendication 10, caractérisé en ce que les tôles profilées (25) sont reliées entre elles télescopiquement et sont isolées avec l'interposition de moyens d'étanchéité.

12. Appareillage selon la revendication 1, caractérisé se que les entretoises (11) disposées horizontalement sont reçues par un châssis rigide (29).

13. Appareillage selon la revendication 12, caractérisé en ce que les entretoises horizontales (11) sont reçues par le châssis (29) de façon à pouvoir être déplacées et réglées, au moyen de manchons coulissants (30), et en ce que ces manchons coulissants (30) peuvent être fixés en position par des vis de serrage (31).

14. Appareillage selon la revendication 12, caractérisé en ce que le châssis (29) qui reçoit une plaque de verre (1) mobile en direction verticale, coopère avec des moyens d'actionnement, par exemple des ensembles piston-cylindre pneumatique (32).

15. Appareillage selon la revendication 1, caractérisé en ce que les châssis fixes (29) comportent des alésages de centrage (34), ainsi que des broches de centrage (33) pouvant être accouplées de façon à coopérer avec eux.

16. Appareillage selon la revendication 1, caractérisé en ce que les entretoises (11) disposées horizontalement sont reliées par l'intermédiaire de profils longitudinaux (35) disposés parallèlement, par exemple au moyen d'assemblage à queue d'aronde (36, 37) et sont disposées de façon à pouvoir coulisser télescopiquement.

## Claims

1. Means for illuminating printed circuit boards disposed between two glass plates (1, 2) provided with the current paths for transfer to the circuit board (5), characterised in that clamping elements (15) are provided for each glass plate (1, 2), between which elements the edges of the glass plates (1, 2) can be clamped; the clamping elements (15) have movable clamping jaws (15', 15b) on the glass plate side and projecting arms (14) on the opposite side, said arms (14) cooperating with the associated clamping element (15) to form a C-shaped profile; spring means, e.g. coil springs, are disposed between said arms (14) and bear at one end against the arms while at the other end they bear by their free facing ends against the opposite sides of a projecting rib (12) of a horizontal transverse strut (11) whereby the clamping elements (15) are mounted elastically with respect to the transverse strut (11).

2. Means according to claim 1, characterised in that a plurality of spring means (13) disposed side by side are associated with each projecting arm (14) of the C-shaped clamping element (15) (Fig. 15).

3. Means according to claim 1 or 2, characterised in that adjustment and prestressing means (40) are associated with the elastic spring means (13).

4. Means according to claim 1, characterised in that each clamping element (15) consists of a fixed clamping jaw (15a) and a movable clamping jaw (15b); the movable clamping jaw (15b) is slidable and adjustable through the agency of screw means (16); and each clamping jaw (15a, 15b) has a soft elastic protective coating (17) on the side facing the glass plate (1, 2).

5. Means according to claim 1, characterised in that each glass plate (1, 2) is held by a clamping element (15) on at least two opposite sides.

6. Means according to claim 1, characterised in that the horizontally disposed transverse struts (11) have one or more continuous bores (18) operatively connected to a vacuum pump (19).

7. Means according to claim 1, characterised in that sealing means (20) are disposed between the horizontally disposed transverse strut (11) which accommodate the bottom glass plate (2) and the transverse struts (11') which accommodate the top plate (1).

8. Means according to claim 7, characterised in that profiled plates (25) rest, with the interposition of sealing means (26, 27), both on the horizontally disposed transverse struts (11) and on the surface of the corresponding glass plate (1, 2) situated opposite the surfaces of the circuit board (5) therebetween; and the profiled plates are retained adjustably via a displaceable and lockable retaining stay (24) by means of pivotable retaining means (21, 22) operatively connected to the horizontally disposed transverse struts (11).

9. Means according to claim 8, characterised in that the profiled plates (25) enclose absolutely hermetically the sandwich packet (7) consisting of the glass plates (1, 2) and circuit board (5) in the peripheral direction, and the fixing means (15) and the horizontally disposed transverse struts (11) and form a sealed chamber (28) which extends in the peripheral direction and which is adapted to be evacuated via continuous bores (18) by means of a vacuum pump (19).

10. Means according to claim 9, characterised in that the end of each profiled plate (25) extending towards the glass plates (1, 2) rests thereon (a) in

the interior of a surface described by the peripheral lines of the circuit board (5) for the electronic circuit.

11. Means according to claim 10, characterised in that the profiled plates (25) are interconnected telescopically and are sealed with the interposition of sealing means.

12. Means according to claim 1, characterised in that the horizontally disposed transverse struts (11) are accommodated by a rigid frame (29).

13. Means according to claim 12, characterised in that the horizontal transverse struts (11) are accommodate by the frame (29) displaceably and adjustably via sliding sleeves (30) and said sliding sleeves (30) are lockable in their position by clamping screws (31).

14. Means according to claim 12, characterised in that the frame (29) accommodating a vertically movable glass plate (1) is operatively connected to actuating means, e.g. pneumatic jacks (32).

15. Means according to claim 1, characterised in that the fixed frames (29) have centring bores (33, 34) and centring pins (33, 34) adapted to be brought into operative connection therewith.

16. Means according to claim 1, characterised in that the horizontally disposed transverse struts (11) are connected via parallel longitudinal profiles (35), e.g. by means of dovetail connections (36, 37) and are arranged for telescopic displacement.

FIG. 1

FIG. 2

FIG. 3

FIG. 4

FIG. 5

FIG. 6

FIG. 7

2

0 039 445

_FIG. 8_

_FIG. 10_

_FIG. 9_

FIG. 11

FIG.12

FIG. 14

FIG. 15

FIG. 13